Europäisches Patentamt

European Patent Office

Office européen des brevets

(11) Veröffentlichungsnummer: **0 436 823 A1**

## (12) EUROPÄISCHE PATENTANMELDUNG

(21) Anmeldenummer: **90122762.9**

(22) Anmeldetag: **28.11.90**

(51) Int. Cl.5: **H03K 19/0175, H03K 19/0185**

(30) Priorität: **12.01.90 DE 4000780**

(43) Veröffentlichungstag der Anmeldung:
**17.07.91 Patentblatt 91/29**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Barré, Claude, Dipl.-Ing.**
**Implerstrasse 23**
**W-8000 München 70(DE)**

(54) **Signalpegelwandler.**

(57) Ein Signalpegelwandler zur Umsetzung von CMOS-Logik-Eingangssignalpegeln auf CML-Eingangssignalpegeln auf CML- bzw. ECL-Ausgangssignalpegel besteht aus einer als Stromschalter dienenden Differenzverstärkeranordnung mit einem ersten und einem zweiten Verstärkerast. Der erste Verstärkerast weist einen Steuertransistor (ST) und der zweite Verstärkerast einen Referenztransistor (RT) auf. Um den Signalpegelwandler zur Bildung von Logik verwenden zu können, ist der Steuertransistor (ST) als Feldeffekttransistor ausgebildet, da Feldeffekttransistoren gegenüber Bipolartransistoren kein Sättigungsverhalten aufweisen.

FIG 2

EP 0 436 823 A1

## SIGNALPEGELWANDLER

Die Erfindung betrifft einen Signalpegelwandler gemäß dem Oberbegriff des Patentanspruchs 1.

Solche Signalpegelwandler sind im allgemeinen dazu vorgesehen, den von einem CMOS-Logiksignalpegel repräsentierten binären Wert nach CMOS-Maßgaben zu identifizieren und einen entsprechenden, nach Maßgaben der Stromschalterlogik (CML) bzw. emittergekoppelten Logik (ECL) zur Repräsentation dieses binären Wertes vorgesehenen Signalpegel zu erzeugen.

Gegenüber den Signalpegeln der CMOS-Logik, bei denen die Spannungswerte für die digitalen L- und H-Pegel den Werten der Versorgungsspannungspotential entsprechen, liegt bei der Stromschalterlogik (CML) der digitale H-Pegel beim positveren Wert der beiden Versorgungsspannungspotential und der digitale L-Pegel bei einem nur ca. 0,5 Volt negativeren Spannungswert. Im Falle der emitterkoppelten Logik (ECL) liegt der digitale H-Pegel ca. 0,9 Volt und der digitale L-Pegel ca. 1,7 Volt negativer als der positivere Wert der beiden Versorgungsspannungspotentiale.

Geht man von einer Versorgungsspannungspotentialdifferenz von ca. 5 Volt aus, so muß ein Signalpegelwandler zur Umsetzung von CMOS-Logikeingangssignalpegeln auf CML- bzw. ECL-Ausgangssignalpegel einen Eingangs-Signalpegelhub von 5 Volt auf einen Ausgangs-Signalpegelhub von 0,5 Volt für CML und ECL - unter Berücksichtigung jeweiliger Störabstände - umsetzen.

Ein bekannter Signalpegelwandler zur Umsetzung von CMOS-Logik-Eingangssignalpegeln auf CML- bzw. ECL-Ausgangssignalpegel, im folgenden CMOS-CML/ECL-Pegelwandler genannt , besteht aus einer geringfügig modifizierten Schaltstufe der CML- bzw. ECL-Schaltungstechnik.

Eine solche Schaltstufe der CML- bzw. ECL-Schaltungstechnik ist aus einem konstantstromgespeisten Differenzverstärker mit einem ersten und einem zweiten Verstärkerast gebildet, die jeweils einen als NPN-Transistor ausgebildeten Steuer- bzw. Referenztransistor aufweisen. Die Emitterelektroden der beiden NPN-Transistoren sind miteinander verbunden und an die Konstantstromquelle angeschlossen. Die Basiselektrode des Steuertransistors dient als Schaltstufeneingang, die des Referenztransistors ist mit einem konstanten Referenzspannungspotential beaufschlagt, das die Schaltschwelle der Schaltstufe festlegt und damit den Spannungswert aufweist, der am Schaltstufeneingang über- oder unterschritten werden muß, damit die Schaltstufe umschaltet.

Die Kollektorelektroden beider NPN-Transistoren stellen komplementäre Schaltstufenausgänge zur Verfügung und sind über je einen Arbeitswiderstand an das positivere der beiden Versorgungsspannungspotentiale angeschlossen, das auch als Pegelbezugspotential bezeichnet wird, da es einen digitalen CML- und CMOS-H-Pegel repräsentiert.

Zur Bildung des bekannten CMOS-CML/ECL-Pegelwandlers wird einer solchen Schaltstufe ein Referenzspannungspotential zugeführt, das einen in der Mitte zwischen den beiden Spannungswerten für die digitalen Pegel der CMOS-Schaltungstechnik liegenden Wert aufweist (bei 0 Volt für den digitalen H-Pegel und -5 Volt für den digitalen L-Pegel hat das Referenzspannungspotential demnach den Wert von -2,5 Volt).

Außerdem muß der Arbeitswiderstand des Steuertransistors entfallen, da der Schaltstufeneingang als Signalpegelwandlereingang dient und der Steuertransistor im leitenden Zustand bereits eine sehr geringe Kollektor-Emitterspannung aufweist, so daß die Sättigung des Steuertransistors nur ohne Arbeitswiderstand sicher verhindert werden kann. Eine Sättigung des Steuertransistors führt bekanntlich zu einer unerwünschten Signallaufzeiterhöhung.

Der bekannte Signalpegelwandler stellt damit keine komplementären Signalpegelwandlerausgänge zur Verfügung. Auch eine Serienschaltung von mehreren Steuertransistoren im ersten Verstärkerast zur Bildung einer logischen UND-Verknüpfung, ist aus dem gleichen Grund nicht realisierbar. Eine Parallelschaltung von mehreren Steuertransistoren zur Bildung einer logischen ODER-Verknüpfungsschaltung ist ebenfalls nicht machbar, da bei gegenphasigen Eingangssignalpegeln die maximale Basisemitterspannung eines sperrenden Steuertransistores überschritten wird.

Aufgabe der vorliegenden Erfindung ist es daher, einen Signalpegelwandler nach dem Oberbegriff des Patentanspruchs 1 so weiterzubilden, daß der weitergebildete Signalpegelwandler mit geringem Aufwand modifiziert werden kann, so daß zusätzlich zur Pegelwandlung auch noch logische Funktionen realisierbar sind.

Gelöst wird die Aufgabe erfindungsgemäß durch die kennzeichnenden Merkmale des Patentanspruchs 1.

Ein als Feldeffekttransistor ausgebildeter Steuertransistor bietet gegenüber einem Bipolartransistor im Hinblick auf den Erfindungsgegenstand den wesentlichen Vorteil, daß seine Drain-Source-Spannung beliebig gering werden darf, ohne daß sich, wie bei einem Bipolartransistor ein Sättigungszustand einstellt.

Bei einem gemäß der Erfindung ausgebildeten Signalpegelwandler ist es als vorteilhaft anzusehen, daß das Referenzspannungspotential nicht notwendigerweise einen, in der Mitte zwischen den beiden Spannungswerten für die digitalen CMOS-Pegel liegenden Wert aufweisen muß. Der Aufwand für die Bildung des Referenzspannungspotentials kann somit verringert werden, zumal als Referenzspannungspotential auch das für Schaltstufen der CML- bzw. ECL-Schaltungstechnik zur Festlegung der Schaltschwelle gebildete Referenzspannungspotential verwendet werden kann.

Ist der Steuertransistor als P-Kanal-Feldeffekttransistor ausgebildet, so wird die Schaltschwelle des Signalpegelwandlers nicht durch die Höhe des Referenzspannungspotentials beeinflußt.

Vorteilhafte Weiterbildungen der Erfindung sind in den Unteransprüchen angegeben.

Da sich ein gemäß der Erfindung ausgebildeter Signalpegelwandler mit geringen schaltungstechnischen Mitteln zur Realisierung von logischen Funktionen erweitern läßt, können aufwendige Logikschaltstufen zur Bildung dieser Funktionen eingespart werden. Dadurch wird die Gatterdichte auf einem integrierten Schaltkreis erhöht und die Signallaufzeit sowie die Verlustleistung wird verringert.

Mit einem als Feldeffekttransistor ausgebildeten Referenztransistor entfällt die Zuführung eines außerhalb des Signalpegelwandlers erzeugten Referenzspannungspotentials. Damit sind auch keine Bauteile zur Erzeugung des Referenzspannungspotentials erforderlich.

Anhand der Zeichnung werden im folgenden mehrere Ausführungsbeispiele der Erfindung näher erläutert.

Dabei zeigen

FIG 1 einen bekannten CMOS-CML/ECL-Signalpegelwandler

FIG 2 einen gemäß der Erfindung weitergebildeten CMOS-CML-Signalpegelwandler zur Bildung einer logischen UND-ODER-Verknüpfung mehrerer CMOS-Eingangssignale und mit komplementären Signalpegelwandlerausgängen

FIG 3 einen gemäß der Erfindung weitergebildeten CMOS-CML-Signalpegelwandler zur Bildung einer logischen Verknüpfung zweier CMOS-Eingangssignale sowie mit einem Freischalteeingang

FIG 4 einen gemäß der Erfindung weitergebildeten CMOS-CML-Signalpegelwandler zur Bildung einer 1 aus 3 Decoderlogik

FIG 5 einen gemäß der Erfindung weitergebildeten CMOS-CML-Signalpegelwandler zur Bildung einer Signalauswahllogik

FIG 6 einen gemäß der Erfindung weitergebildeten CMOS-CML-Signalpegelwandler unter Verwendung des Pegelbezugspotentials als Referenzspannungspotential bei einem als Feldeffekttransistor ausgebildeten Referenztransistor

FIG 7 einen gemäß der Erfindung weitergebildeten CMOS-CML-Signalpegelwandler zur Bildung einer UND-Verknüpfung unter Verwendung von CMOS-Eingangssignalen als Referenzspannungspotentiale für als Feldeffekttransistoren ausgebildete Referenztransistoren

FIG 8 einen gemäß der Erfindung weitergebildeten CMOS-CML-Signalpegelwandler unter Verwendung des an einem weiteren Signalpegelwandlerausgang zur Verfügung stehenden CML-Ausgangssignalpegels als Referenzspannungspotential für einen als Feldeffekttransistor ausgebildeten Referenztransistor.

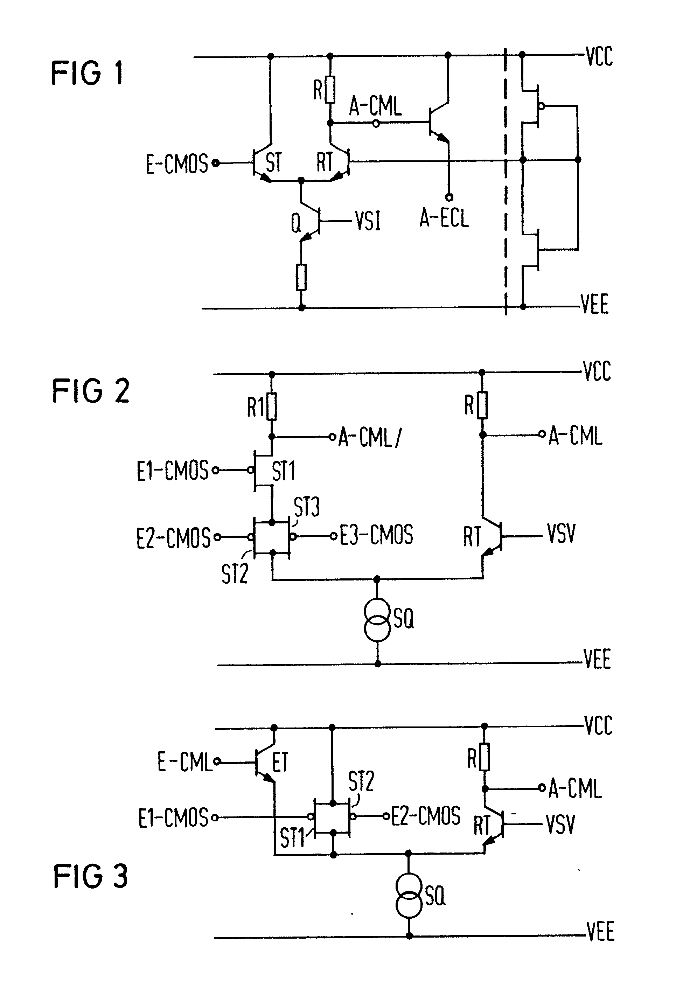

In der FIG 1 ist ein Schaltbild für einen bekannten CMOS-CML/ ECL-Signalpegelwandler dargestellt. Der bekannte Signalpegelwandler ist aus einer Schaltstufe der CML-Schaltungstechnik gebildet und besteht aus einer, als Stromschalter dienenden Differenzverstärkeranordnung mit einem ersten und einem zweiten aus einer gemeinsamen Konstantstromquelle gespeisten Verstärkerast. Zur Spannungsversorgung der Schaltstufe sind zwei Versorgungsspannungspotentiale VEE, VCC mit einem Spannungswert von - 5Volt bzw. 0 Volt vorgesehen. Als Konstantstromquelle dient ein in Form eines NPN-Transistors ausgebildeter Stromquellentransistor ST dessen Emitterelektrode über einen Emitterwiderstand an das negativere der beiden Versorgungsspannungspotentiale VEE angeschlossen ist. Der Basiselektrode des Stromquellentransistors Q ist eine Konstantspannung VSI zugeführt, deren Spannungswert in Abhängigkeit des Emitterwiderstandes den Kollektorstrom des Stromquellentransistors Q festlegt.

Der erste Verstärkerast führt von der Kollektroelektrode des Stromquellentransistors Q über die Emitter-Kollektor-Strecke eines als NPN-Transistor ausgebildeten Steuertransistors ST zum positiveren der beiden Versorgungsspannungspotentiale VCC (0 Volt), das zugleich als Pegelbezugspotential für CMOS-H-Pegel und CML-H-Pegel dient.

Die Basiselektrode des Steuertransistors ST dient als Signalpegelwandlereingang E-CMOS für CMOS-Eingangssignalpegel, die durch die Spannungswerte der beiden Versorgungsspannungspotentiale VCC, VEE repräsentiert werden.

Der zweite Verstärkerast führt von der Kollektorelektrode des Stromquellentransistors Q über die Emitter-Kollektorstrecke eines als NPN-Transistor ausgebildeten Referenztransistors RT und über einen mit seiner Kollektorelektrode verbundenen Arbeitswiderstand R ebenfalls zum positiveren der beiden Versorgungsspannungspotentiale VCC.

Ein mit der Kollektorelektrode des Referenztransistors RT und damit mit dem Arbeitswiderstand R verbundener Abgriff bildet einen Signalpegelwandlerausgang A-CML für CML-Ausgangssignalpegel und ist bei Bedarf an die Basiselektrode eines als NPN-Transistor ausgebildeten Emitterfolgers angeschlossen. Die Kollektorelektrode des Emitterfolgers ist mit dem positiveren der beiden Versorgungsspannungspotentiale VCC verbunden, seine Emitterelektrode dient als Signalpegelwandlerausgang A-ECL für ECL-Ausgangssignalpegel.

Die Basiselektrode des Referenztransistors RT ist mit einem Referenzspannungspotential beaufschlagt, das mit Hilfe eines überbrückten CMOS-Inverters erzeugt wird.

Der überbrückte CMOS-Inverter (in der FIG mittels einer unterbrochenen Linie vom Signalpegelwandler abgesetzt) besteht aus einer Reihenschaltung eines P-Kanal- und eines N-Kanal MOS-Feldeffekttransistors, deren Drain- und Gateelektroden miteinander verbunden sind und eine Verbindungsleitung zur Basis des Referenztransistors RT aufweisen.

Mit dem überbrückten CMOS-Inverter wird ein, in der Mitte zwischen den beiden Versorgungsspannungspotentialen VCC, VEE liegender Spannungswert (also - 2,5 Volt) erzeugt, so daß die Schaltschwelle des Signalpegelwandlers genau in der Mitte zwischen den beiden Spannungswerten für digitalen CMOS-Pegel liegt.

Ist der Spannungswert des CMOS-Eingangssignals wenigstens um ca. 100 Millivolt positiver als das Referenzspannungspotential, so fließt der von der Konstantstromquelle erzeugte Strom z.B. 1 Milliampere vollständig durch den ersten Verstärkerast, ist der Spannungswert des CMOS-Eingangssignales wenigstens um 100 Millivolt negativer, dann fließt der Strom vollständig durch den zweiten Verstärkerast.

Ein CMOS-H-Pegel am Signalpegelwandlereingang E-CMOS führt damit nicht zu einem Spannungsabfall am Arbeitswiderstand R im zweiten Verstärkerast. Am Signalpegelwandlerausgang A-CML steht also ein CML-H-Pegel zur Verfügung. Bei einem CMOS-L-Pegel am Signalwandlereingang E-CMOS ist der Referenztransistor RT leitend und am Arbeitswiderstand R, der z.B. einen ohmschen Wert von ca. 500 Ohm aufweist, bildet sich ein Spannungsabfall von etwa 0,5 Volt, der dem Betrage nach dem CML-L-Pegel entspricht.

Eine Sättigung des Steuertransistors ST bei einem anliegenden CMOS-H-Pegel am Signalpegelwandlereingang E-CMOS kann nicht eintreten, da wegen eines fehlenden Arbeitswiderstandes im ersten Verstärkerast die Kollektor-Emitterspannung nicht geringer als 0,7 Volt (entspricht der Basis-Emitterspannung) werden kann und damit weit über der Sättigungsspannung von ca. 0,2 Volt liegt.

In der FIG 2 ist ein Schaltbild für einen gemäß der Erfindung weitergebildeten CMOS-ECL-Pegelwandler dargestellt, der ebenso wie der bekannte Signalpegelwandler nach FIG 1 aus einer als Stromschalter dienenden Differenzverstärkeranordnung besteht, die mit einem ersten und mit einem zweiten aus einer gemeinsamen Konstantstromquelle gespeisten Verstärkerast gebildet ist. Die Konstantstromquelle ist zu der des bekannten Signalpegelwandlers identisch ausgebildet und ist zur Vereinfachung der Zeichnung in Form eines Stromquellensymboles dargestellt.

Der erste Verstärkerast weist drei, als selbstsperrende P-Kanal MOS-Feldeffekttransistoren ausgebildete Steuertransistoren ST1, ST2, ST3 auf. Da diese im folgenden als PMOS-FET's bezeichneten Feldeffekttransistoren hinsichtlich ihrer Drain-Source-Elektrodenanordnung symmetrisch ausgebildet sind, ist die auf positiverem Spannungspotential liegende Elektrode stets die Source-Elektrode.

Im einzelnen setzt sich der erste Verstärkerast wie folgt zusammen. An die Stromquelle SQ sind die Drain-Elektroden eines zweiten und eines dritten, Steuerungstransistors ST2, ST3 angeschlossen. Die miteinander verbundenen Source-Elektroden des zweiten und dritten Steuerungstransistors ST2, ST3 sind auf die Drain-Elektrode eines ersten Steuerungstransistors ST1 geführt, dessen Source-Elektrode einen als Signalpegelwandlerausgang A-CML/ dienenden Abgriff aufweist und über einen weiteren Arbeitswiderstand mit dem positiveren der beiden Versorgungsspannungspotentiale VCC verbunden ist. Die Gate-Elektroden der drei Steuerungstransistoren ST1, ST2, ST3 dienen als Signalpegelwandlereingänge E1-CMOS, E2-CMOS, E3-CMOS für CMOS-Eingangssignalpegel.

Der zweite Verstärkerast besteht aus einem als NPN-Transistor ausgebildeten Referenztransistor RT, der mit seiner Emitterelektrode an die Stromquelle SQ und mit seiner Kollektorelektrode über einen Arbeitswiderstand R an das positivere der beiden Versorgungsspannungspotentiale VCC angeschlossen ist. An der Kollektorelektrode des Referenztransistors RT ist zudem ein Abgriff vorhanden, der als logisch komplementärer Signalpegelwandlerausgang A-CML für CML-Signalpegel dient. Die Basiselektrode des Referenztransistors RT ist mit einem Referenzspannungspotential in Höhe etwa - 0,25 Volt beaufschlagt, daß auch für eine Festlegung der Schaltschwelle bei CML-Schaltstufen benötigt wird und in der Regel bereits zur Verfügung steht.

Durch die Reihen- und Parallelschaltung der drei Steuerungstransistoren ST1, ST2, ST3 wird eine logische Verknüpfung der digitalen Eingangswerte realisiert, da im ersten Verstärkerast nur dann Strom fließt, wenn sowohl an der Basiselektrode des ersten Steuerungstransistors ST1 als auch wenigstens an einer der Basiselektroden des zweiten oder dritten Steuerungstransistors ST2, ST3 ein CMOS-L-Pegel anliegt. Da beide Verstärker einen Arbeitswiderstand und einen als Signalpegelwandlerausgang dienenden Abgriff aufweisen, verhalten sich die digitalen Werte an beiden Signalpegelwandlerausgängen A-CML, A-CML/ zueinander komplementär.

Ein CMOS-H-Pegel an der Gateelektrode eines Steuerungstransistors erzielt eine Gate-Source-Spannung von 0 Volt, der betreffende Steuertransistor ist damit extrem hochohmig. Bei einem CMOS-L-Pegel an der Gateelektrode ist der betreffende Steuertransistor durchgeschaltet. Fließt der Strom (z.B. 1 Milliampere) aus der Konstantstromquelle SQ durch den ersten Verstärkerast, so bildet sich am Arbeitswiderstand des ersten Verstärkerastes ein Spannungsabfall von 0,5 Volt der im Betrage nach einem CML-L-Pegel entspricht.

Die Steuertransistoren ST1, ST2, ST3 sind hinsichtlich ihres Schwellpunktes so dimensioniert, daß die Schaltschwelle des Signalpegelwandlers in etwa in der Mitte zwischen den beiden Spannungswerten für die digitalen CMOS-Signalpegel liegt.

In der FIG 3 ist ein Schaltbild für einen gemäß der Erfindung zur Ausführung logischer Funktionen ergänzter CMOS-CML-Signalpegelwandler dargestellt, der einen Freischalteeingang zur Zuführung eines CML-Signalpegels aufweist.

Auch dieser Signalpegelwandler besteht aus einem ersten und einem zweiten von einer gemeinsamen Konstantstromquelle SQ gespeisten Verstärkerast. Der erste Verstärkerast weist zur Bildung einer logischen ODER-Verknüpfung zwei parallel geschaltete, als PMOS-FET's ausgebildete Steuertransistoren ST1, ST2 auf, die mit ihren Drain-Elektroden an die Konstantstromquelle SQ und mit ihren Source-Elektroden an das positivere der beiden Versorgungsspannungspotentiale VCC angeschlossen sind.

Ein als NPN-Transistor ausgebildeter Eingangstransistor ET ist mit seiner Emitterelektrode an die Konstantstromquelle SQ und mit seiner Kollektorelektrode an das positivere der beiden Versorgungsspannungspotentiale VCC angeschlossen und ist damit dem ersten Verstärkerast parallel geschaltet.

Die Basiselektrode des Eingangstransistors dient als Freischalteeingang E-CML des Signalpegelwandlers und wird mit CML-Signalpegeln beaufschlagt. Die Gateelektroden der beiden Steuertransistoren ST1, ST2 dienen als Signalpegelwandlereingänge E1-CMOS bzw. E2-CMOS für CMOS-Signalpegel.

Der zweite Verstärkerast ist identisch zu dem des Signalpegelwandlers nach FIG 2 ausgebildet.

Für den Fall, daß am Freischalteeingang E-CML des Signalpegelwandlers ein CML-H-Pegel (0 Volt) anliegt, fließt kein Strom durch den Referenztransistor RT. Am Signalpegelwandlerausgang A-CML des zweiten Verstärkerastes liegt somit ein CML-H-Pegel an.

Bei einem CML-L-Pegel am Freischalteeingang E-CML fließt der Strom der Konstantstromquelle nur dann durch den zweiten Verstärkerast (d.h. am Signalpegelwandlerausgang A-CML stellt sich ein CML-L-Pegel ein), wenn an beiden Signalpegelwandlereingängen E1-CMOS, E2-CMOS ein CMOS-H-Pegel anliegt. Der Signalpegelwandler führt damit eine logische Nicht-Oder-Verknüpfung aus.

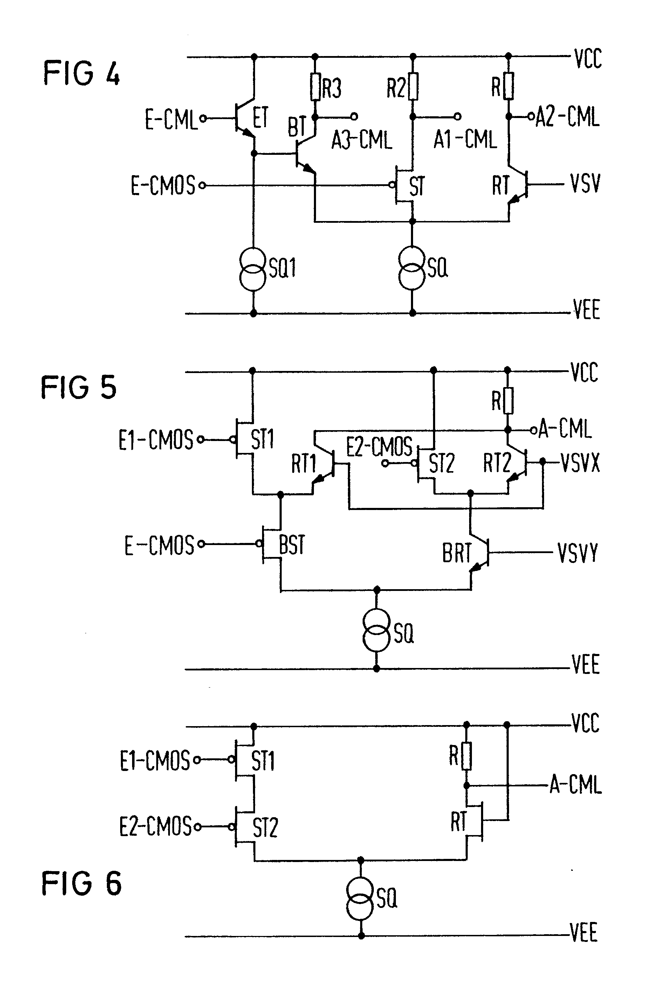

In der FIG 4 ist ein Schaltbild für einen gemäß der Erfindung mit einer Eins aus drei Decodierlogik ergänzten CMOS-CML-Signalpegelwandler dargestellt.

Auch dieser Signalpegelwandler weist einen ersten und einen zweiten, aus einer gemeinsamen Konstantstromquelle SQ gespeisten Verstärkerast auf. Im ersten Verstärkerast ist ein als PMOS-Fet ausgebildeter Steuertransistor ST angeordnet, der mit seiner Drain-Elektrode an die Konstantstromquelle SQ und mit seiner Source-Elektrode über einen Arbeitswiderstand an das positivere der beiden Versorgungsspannungspotentiale VCC angeschlossen ist. Ein mit der Source-Elektrode verbundener Abgriff bildet einen Signalpegelwandlerausgang A1-CML für CML-Signalpegel. Die Gateelektrode des Steuertransistors ST dient als Signalpegelwandlereingang E-CMOS für CMOS-Signalpegel.

Der zweite Verstärkerast ist zu dem des Signalpegelwandlers nach FIG 2 oder FIG 3 identisch ausgebildet.

Einen dritten Verstärkerast bildet ein als NPN-Transistor ausgebildeter Brückentransistor BT, dessen Emitterelektrode mit der Konstantstromquelle SQ und dessen Kollektorelektrode über einen dritten Arbeitswiderstand R3 mit dem positiveren der beiden Versorgungsspannungspotentiale VCC verbunden ist.

Ein Abgriff an der Kollektorelektrode des Brückentransistors BT dient als dritter Signalpegelwandlerausgang A3-CML für CML-Ausgangssignalpegel.

Die Basis des Brückentransitors BT ist mit einer weiteren, an das negativere der beiden Versorgungsspannungspotentiale angeschlossenen Stromquelle SQ1 und über die Emitter-Kollektorstrecke eines als NPN-Transistor ausgebildeten und als Emitterfolger arbeitenden Eingangstransistors ET mit dem positiveren der beiden Versorgungsspannungspotentiale VCC verbunden. Die Basiselektrode des Eingangstransistors ET wird mit CML-Eingangssignalpegeln beaufschlagt und dient als Auswahleingang für die mit dem Signalpegelwandler gebildete 1 aus drei der Decodierlogik.

Der Eingangstransistor ET in Verbindung mit der weiteren Stromquelle SQ1 dient dazu, die Basisspannung am Brückentransistor BT im leitenden Zustand also bei einem anliegenden CML-H-Pegel nicht so positiv werden zu lassen, daß der Brückentransistor BT aufgrund des Spannungsabfalls am dritten Arbeitswiderstandes R3 in Sättigung geht.

Nachstehend ist zum besseren Verständnis der logischen Funktion einer 1 aus drei der Codierlogik eine Wertetabelle angegeben, die in Abhängigkeit der digitalen Eingangssignalpegelkombinationen am Auswahleingang E-CML und am Signalpegelwandlereingang E-CMOS die sich an den Signalpegelwandlerausgängen A1-CML, A2-CML, A3-CML einstellenden digitalen Ausgangssignalpegel angibt.

| E-CML | C-CMOS | A1-CML | A2-CML | A3-CML |
|-------|--------|--------|--------|--------|
| L | L | L | H | H |
| L | H | H | L | H |
| H | L | L | H | H |
| H | H | H | H | L |

In der FIG 5 ist ein Schaltbild für einen gemäß der Erfindung zur Bildung einer Signalauswahllogik ausgestalteten CMOS-CML-Signalpegelwandlers dargestellt. Dieser Signalpegelwandler besteht aus einem Basisdifferenzverstärker mit einem ersten und einem zweiten von einer gemeinsamen Konstantstromquelle gespeisten Basisverstärkerast, in denen jeweils ein nachgeschalteter Differenzverstärker angeordnet ist.

Im ersten Basisverstärkerast befindet sich ein als PMOS-FET ausgebildeter Basissteuertransistor BST, der mit seiner Drain-Elektrode an die Konstantstromquelle SQ angeschlossen ist und an seiner Source-Elektrode mit den beiden Verstärkerästen des im ersten Basisverstärkerastes angeordneten nachgeschalteten Differenzverstärkers verbunden ist.

Der zweite Basisverstärkerast weist einen als NPN-Transistor ausgebildeten Basisreferenztransistor BRT auf, dessen Emitterelektrode an die Konstantstromquelle SQ angeschlossen ist und dessen Kollektorelektrode mit den beiden Verstärkerästen des im zweiten Basisverstärkerast angeordneten nachgeschalteten Differenzverstärkers in Verbindung steht.

Die nachgeschalteten Differenzverstärker sind identisch aufgebaut und bestehen jeweils aus einem ersten und einem zweiten Verstärkerast mit einem als PMOS-Fet ausgebildeten Steuertransistor ST1; ST2 im ersten Verstärkerast und einem als NPN-Transistor ausgebildeten Referenztransistor RT1; RT2 im zweiten Verstärkerast.

Bei dem nachgeschalteten Differenzverstärker des ersten Basisverstärkerastes ist die Drain-Elektrode des Steuertransistors ST1 mit der Emitterelektrode des Referenztransistors RT1 verbunden und an die Source-Elektrode des Basis-Steuertransistors BST angeschlossen. Analog dazu ist beim nachgeschalteten Differenzverstärker des zweiten Basisverstärkerastes die Drain-Elektrode des Steuertransistors ST2 mit der Emitterelektrode des Referenztransistors RT2 verbunden und an die Kollektorelektrode des Basisreferenztransistors BRT angeschlossen.

Mit ihren Source-Elektroden sind die Steuertransistoren ST1, ST2 an das positivere der beiden Versorgungsspannungspotentiale VCC geführt. Die Referenztransistoren RT1, RT2 der beiden nachgeschalteten Differenzverstärker sind an ihren Kollektorelektroden miteinander verbunden und über einen Arbeitswiderstand R ebenfalls an das positivere der beiden Versorgungsspannungspotential VCC geführt. Ein Abgriff an der Kollektorelektrode der Referenztransistoren RT1, RT2 und damit am Arbeitswiderstand R dient als Signalpegelwandlerausgang A-CML für CML-Signalpegel.

Die Basiselektroden der beiden Referenztransistoren RT1, RT2 in den nachgeschalteten Differenzverstärkern sind miteinander verbunden und werden mit einem ersten Referenzspannungspotential VSVX beaufschlagt, dessen Spannungswert in etwa zwischen den beiden Spannungswerten für die digitalen CML-Pegel also bei ca. - 0,25 Volt liegt.

An die Basiselektrode des Basisreferenztransistors BRT ist ein zweites Referenzspannungspotential VSVY geführt dessen Spannungswert gegenüber dem des ersten Referenzspannungspotentials VSVX wenigstens um die Sättigungsspannung des Basisreferenztransistors BRT negativer ist, also in etwa - 1,0 Volt beträgt.

Die Gate-Elektrode des Basissteuertransistors BST dient als Auswahleingang E-CMOS für CMOS-Signalpegel und die Gate-Elektroden der zu den nachgeschalteten Differenzverstärkern gehörenden Steuertransistoren ST1, ST2 dienen als Signalpegelwandlereingänge E1-CMOS, E2-CMOS für CMOS-Signalpegel.

Nachstehend ist zum Verständnis der logischen Funktion der in dem Signalpegelwandler implementierten Signalauswahllogik eine Wertetabelle aufgeführt, die in Abhängigkeit der digitalten Eingangssignalpegelkombinationen an dem Auswahleingang E-CMOS und an den beiden Signalpegelwandlereingängen E1-CMOS, E2-CMOS den zugeordneten digitalen Ausgangssignalpegel am Signalpegelwandlerausgang A-CML angibt.

| E-CMOS | E1-CMOS | E2-CMOS | A-CML |
|--------|---------|---------|-------|
| L | L | L | H |
| L | L | H | H |
| L | H | L | L |
| L | H | H | L |
| H | L | L | H |
| H | L | H | L |
| H | H | L | H |
| H | H | H | L |

Aus dieser Wertetabelle ist ersichtlich, daß bei einem L-Pegel am Auswahleingang E-CMOS die am Signalpegelwandlereingang E1-CMOS anliegenden Pegelwerte, und bei einem H-Pegel am Auswahleingang E-CMOS die am Signalpegelwandlereingang E2-CMOS anliegenden Pegelwerte logisch invertiert auf den Signalpegelwandlerausgang A-CML durchgeschaltet werden.

In der FIG 6 ist ein Schaltbild für einen gemäß der Erfindung mit einem als Feldeffekttransistor ausgebildeten Referenztransistor versehenen CMOS-CML-Signalpegelwandler dargestellt. Auch dieser Signalpegelwandler besteht aus einem ersten und einem zweiten von einer gemeinsamen Konstantstromquelle gespeisten Verstärkerast. Der erste Verstärkerast weist zur Bildung einer logischen UND-Verknüpfung zwei in Reihe geschaltete und als PMOS-Fet's ausgebildete Steuertransistoren ST1, ST2 auf, deren Gate-Elektroden als Signalpegelwandlereingänge E1-CMOS, E2-CMOS für CMOS-Signalpegel dienen.

Im zweiten Verstärkerast ist ein als selbstsperrender N-Kanal-MOS-Fet, im folgenden N-MOS-Fet abgekürzt, ausgebildeter Referenztransistor RT angeordnet, dessen Source-Elektrode an die Konstantstromquelle SQ und dessen Drain-Elektrode über einen Arbeitswiderstand R an das positivere der beiden Versorgungsspannungspotentiale VCC angeschlossen ist. Ein Abgriff an der Drain-Elektrode und damit am Arbeitswiderstand R dient als Signalpegelwandlerausgang A-CML für CML-Signalpegel. Die Gate-Elektrode des Referenztransistors RT ist an das positivere der beiden Versorgungsspannungspotentiale VCC angeschlossen.

Der Strom der Konstantstromquelle SQ fließt nur dann durch den ersten Verstärkerast, wenn an beiden Signalpegelwandlereingängen E1-CMOS, E2-CMOS ein L-Pegel anliegt. Denn dann sind die beiden Steuertransistoren ST1, ST2 niederohmig und zugleich ist die Gate-Source-Spannung am Referenztransistor RT unter den Schwellpunkt des Referenztransistors RT abgesunken wodurch der Referenztransistor RT hochohmig wird.

Liegt an einem der Signalpegelwandlereingängen E1-CMOS, E2-CMOS ein H-Pegel an, so ist der erste Verstärkerast hochohmig und die Gate-Source-Spannung am Referenztransistor RT liegt über dem Schwellpunkt des Referenztransistors RT. Am Signalpegelwandlerausgang A-CML stellt sich ein Spannungwert von - 0,5 Volt entsprechend einem CML-L-Pegel ein.

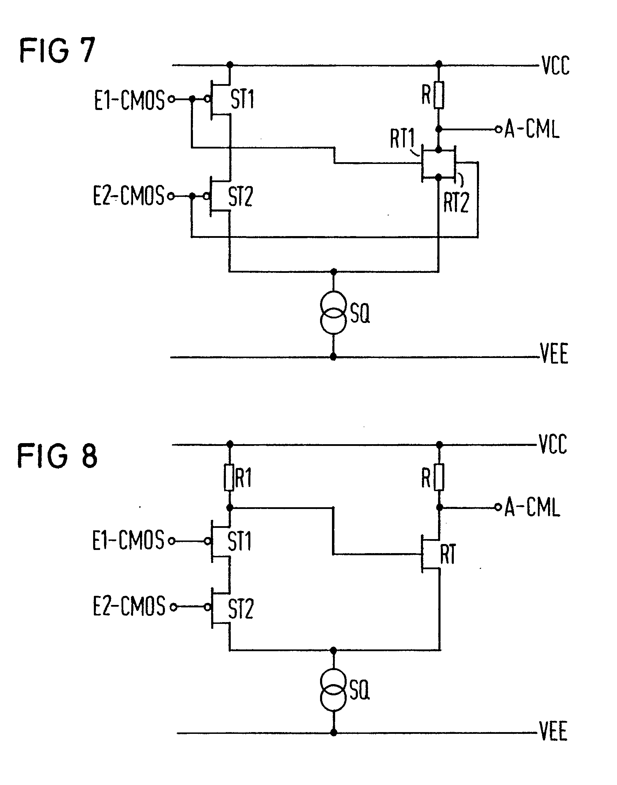

In der FIG 7 ist ein Schaltbild für einen gemäß der Erfindung mit komplementär zugeordneten Referenztransistoren versehenen CMOS-CML-Signalpegelwandler dargestellt. Im Unterschied zu dem Signalpegelwandler nach FIG 6 ist bei diesem Signalpegelwandler jedem Steuertransistor ST1, ST2 im ersten Verstärkerast eindeutig ein als N-MOS-Fet ausgebildeter Referenztransistor RT im zweiten Verstärkerast zugeordnet. Das von den Referenztransistoren RT1, RT2 gebildete Schaltnetz ist komplementär zu dem der Steuertransistoren ST1, ST2 ausgebildet. Im vorliegenden Beispiel sind die Steuertransistoren ST1, ST2 zur Bildung einer UND-Verknüpfung in Reihe geschaltet, die Referenztransistoren RT1, RT2 sind deshalb zur Bildung des komplementären Schaltnetzes, also für eine ODER-Verknüpfung, parallel geschaltet.

Die Gate-Elektroden der Steuertransistoren ST1, ST2 dienen als Signalpegelwandlereingänge E1-CMOS, E2-CMOS für CMOS-Signalpegel, und jeder Referenztransistor RT1, RT2 ist mit seiner Gate-Elektrode an die des ihm zugeordneten Steuertransistors ST1, ST2 angeschlossen.

Der Strom der Konstantstromquelle SQ fließt nur dann durch den ersten Verstärkerast, wenn an den beiden Signalpegelwandlereingängen E1-CMOS, E2-CMOS L-Pegel anliegen, denn dann ist die Gate-Source-Spannung an beiden Referenztransistoren RT1, RT2 zu 0 geworden, womit diese dann hochohmig werden.

Für den Fall, daß an den Signalpegelwandlereingängen E1-CMOS, E2-CMOS wenigstens ein CMOS-H-Pegel anliegt, ist der erste Verstärkerast hochohmig und der Strom fließt vollständig durch den zweiten Verstärkerast, da wenigstens einer der Referenztransistoren RT1, RT2 aufgrund einer hohen Gate-Source-Spannung niederohmig wird.

Im Vergleich zum Signalpegelwandler nach FIG 6 weist der Signalpegelwandler nach FIG 7 eine steilere und damit für das Schaltverhalten günstigere Transferkurve auf.

In der FIG 8 ist ein Schaltbild für einen gemäß der Erfindung mit einem als Feldeffekttransistor ausgebildeten Referenztransistor versehenen CMOS-CML-Signalpegelwandler dargestellt. Dieser Signalpegelwandler ist vom Aufbau her dem Signalpegelwandler nach FIG 6 ähnlich. Gegenüber dem Signalpegelwandler nach FIG 6 ist im ersten Verstärkerast ein Arbeitswiderstand R1 vorgesehen der die Reihenschaltung der Steuertransistoren ST1, ST2 und damit die Source-Elektrode des von der Konstantstromquelle SQ abgewandten Steuertransistors ST1 mit dem positiveren der beiden Versorgungsspannungspotentiale VCC verbindet. Außerdem ist an dem Arbeitswiderstand R1 und damit an der Source-Elektrode des Steuertransistors ST1 ein Abgriff vorhanden, der mit der Gate-Elektrode des Referenztransistors verbunden ist.

Liegt wenigstens an einem der beiden Signalpegelwandlereingänge E1-CMOS, E2-CMOS ein H-Pegel an, so fließt der Strom der Konstantstromquelle SQ durch den zweiten Verstärkerast, da die an der Gate-Elektrode des Referenztransistors RT anliegende Spannung dem positiveren der beiden Versorgungsspannungspotentiale VCC entspricht und der Referenztransistor RT aufgrund der auf negativerem Potential liegenden Source-Elektrode niederohmig wird.

Für den Fall, daß an beiden Signalpegelwandlereingängen E1-CMOS, E2-CMOS L-Pegel anliegen, fließt der Strom der Konstantstromquelle SQ durch den ersten Verstärkerast und der Referenztransistor RT wird aufgrund seiner negativer werdenden Gate-Spannung hochohmig.

Im Hinblick auf die Güte der Transverkurve liegt dieser Signalpegelwandler in etwa zwischen der des Signalpegelwandlers nach FIG 6 und dem nach FIG 7.

Abschließend ist darauf hinzuweisen daß die in der Zeichnung gezeigten Signalpegelwandler lediglich Ausführungsbeispiele darstellen und zur Bildung beliebiger logischer Verknüpfungen erweitert werden können. Anstelle eines jeden, als Feldeffekttransistor ausgebildeten Steuertransistors kann eine Parallel-UND/Oder-Reihenschaltung von Steuertransistoren vorgesehen werden.

Obwohl in den Ausführungsbeispielen die Steuertransistoren als selbstsperrende P-Kanal-MOS-Feldeffekttransistoren ausgebildet sind, können die Steurtransistoren z.B. auch als selbstleitende N-Kanal-MOS-Feldeffekttransistoren ausgebildet sein.

Zur Bildung von Signalpegelwandlerausgängen A-ECL für ECL-Signalpegel kann jedem Signalpegelwandlerausgang A-CML für CML-Signalpegel ein Emitterfolger nachgeschaltet werden.

**Patentansprüche**

1. Signalpegelwandler zur Umsetzung von CMOS-Logik-Eingangssignalpegeln auf CML- bzw. ECL-Ausgangssignalpegel unter Verwendung einer als Stromschalter dienenden Differenzverstärkeranordnung mit einem ersten Verstärkerast, der einen Steuertransistor aufweist, dessen Steuerelektrode als Signalpegelwandlereingang für CMOS-Eingangssignalpegel dient und mit einem zweiten Verstärkerast, in dem sich ein Referenztransistor befindet, dessen Steuerelektrode an ein Referenzpotential angeschlossen ist,
   **dadurch gekennzeichnet**, daß der Steuertransistor (ST) als Feldeffekttransistor ausgebildet ist.

2. Signalpegelwandler nach Anspruch 1,
   **dadurch gekennzeichnet,** daß der erste und/oder der zweite Verstärkerast einen Arbeitswiderstand (R1) aufweist, der eingangsseitig an das Pegelbezugspotential angeschlossen ist und ausgangsseitig mit einem Abgriff verbunden ist, der als Signalpegelwandlerausgang (A-CML) für CML-Ausgangssignalpegel dient bzw. an einen Emitterfolger zur Bildung eines Signalpegelwandlerausgangs für ECL-Ausgangssignalpegel angeschlossen ist.

3. Signalpegelwandler nach Anspruch 1 oder 2,
   **dadurch gekennzeichnet,** daß der erste Verstärkerast wenigstens einen weiteren als Feldeffekttransistor ausgebildeten Steuertransistor aufweist, dessen Drain-Source-Strecke zur Bildung einer logischen ODER-Verknüpfung zu der des Steuertransistors parallelgeschaltet bzw. zur Bildung einer logischen UND-Verknüfung in Serie geschaltet ist und dessen Gateelektrode als weiterer Signalpegelwandereingang für CMOS-Eingangssignalpegel dient.

4. Signalpegelwandler nach Anspruch 1 oder 3,
   **dadurch gekennzeichnet,** daß dem ersten Verstärkerast die Kollektor-Emitterstrecke eines als Bipolartransistor ausgebildeten Eingangstransistors ET parallelgeschaltet ist, dessen Basiselektrode als Freigabeeingang E-CML des Signalpegelwandlers für CML-Eingangssignalpegel dient.

5. Signalpegelwandler nach einem der vorhergehenden Ansprüche,
   **dadurch gekennzeichnet,** daß zur Bildung einer eins aus drei Dekodierlogik ein dritter Verstärkerast vorgesehen ist, den ein als Bipolartransistor ausgebildeter Brückentransistor (BT) und ein mit dem Pegelbezugspotential verbundener dritter Arbeitswiderstand (R3) bildet, daß der dem Pegelbezugspotential abgewandte Anschluß des dritten Arbeitswiderstandes (R3) einen Abgriff aufweist, der als dritter Signalpegelwandlerausgang (A3-CML) für CML-Ausgangssignalpegel bzw. über einen Emitterfolger als dritter Signalpegelwandlerausgang für ECL-Ausgangssignalpegel dient, daß die Basiselektrode des Brückentransistors (BT) an eine weitere Stromquelle (SQ1) angeschlossen ist und über die Schaltstrecke eines als Bipolartransistor ausgebildeten und als Emitterfolger geschalteten Eingangstransistors (ET) angeschlossen ist, und daß die Basiselektrode des Eingangstransistors (ET) als Auswahleingang (E-CML) für CML-Eingangssignalpegel dient.

6. Signalpegelwandler nach einem der vorhergehenden Ansprüche,
   **dadurch gekennzeichnet,** daß zur Bildung einer Signalauswahllogik der erste und/oder der zweite Verstärkerast über je eine zu einem Signalpegelwandler nach einem der vorhergehenden Ansprüche ausgebildete nachgeschaltete Differenzverstärkeranordnung mit dem Pegelbezugspotential verbunden ist.

7. Signalpegelwandler nach wenigstens einem der Ansprüche 1 bis 6,
   **dadurch gekennzeichnet,** daß der Referenztransistor als Feldeffekttransistor ausgebildet ist und daß als Referenzpotential das Pegelbezugspotential dient.

8. Signalpegelwandler nach wenigstens einem der Ansprüche 1 bis 6,
   **dadurch gekennzeichnet,** daß der bzw. die Steuertransistoren als P-Kanal-Feldeffekttransistoren ausgebildet sind, daß jedem Steuertransistor ein als N-Kanal-Feldeffekttransistor ausgebildeter Referenztransistor zugeordnet ist, daß die Referenztransistoren ein Schaltnetz bilden, das zu dem der Steuertransistoren komplementär ist und daß die Gate-Elektrode eines jeden Steuertransistors mit der des ihm zugeordneten Referenztransistors verbunden ist.

9. Signalpegelwandler nach wenigstens einem der Ansprüche 1 bis 6,
   **dadurch gekennzeichnet,** daß der Referenztransistor als Feldeffekttransistor ausgebildet ist und daß seine Gateelektrode mit dem Abgriff des im ersten Verstärkerastes angeordneten Arbeitswiderstandes verbunden ist.

9

FIG 1

FIG 2

FIG 3

FIG 4

FIG 5

FIG 6

FIG 7

FIG 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 326 947 (SIEMENS) * Figur 1; Spalte 2, Zeile 18 – Seite 3, Zeile 45 * | 1,2 | H 03 K 19/0175 H 03 K 19/0185 |
| Y | | 3,4 | |
| Y | PATENT ABSTRACTS OF JAPAN, Band 11, Nr. 190 (E-517)[2637], 18. Juni 1987; & JP-A-62 20 420 (HITACHI LTD) 29-01-1987 * Fig.; Zusammenfassung * | 3,4 | |
| A | US-A-4 883 988 (IDE et al.) * Figuren 1-3; Spalte 1, Zeile 25 – Seite 6, Zeile 33 * | 1,3 | |
| A | US-A-4 695 749 (LAM) * Ganzes Dokument * | 5 | |
| A | PATENT ABSTRACTS OF JAPAN, Band 12, Nr. 54 (E-583)[2901], 18. Februar 1988; & JP-A-62 200 819 (NEC CORP.) 04-09-1987 * Fig.; Zusammenfassung * | 7 | |
| A | PATENT ABSTRACTS OF JAPAN, Band 7, Nr. 264 (E-212)[1409], 24. November 1983; & JP-A-58 145 237 (MATSUSHITA DENKI SANGYO K.K.) 30-08-1983 * Fig.; Zusammenfassung * | 3 | |

**RECHERCHIERTE SACHGEBIETE (Int. Cl.5)**

H 03 K
H 03 M

Der vorliegende Recherchenbericht wurde für alle Patentansprüche erstellt

| Recherchenort | Abschlußdatum der Recherche | Prüfer |
|---|---|---|
| DEN HAAG | 08-02-1991 | FEUER F.S. |